# EUROPÄISCHE PATENTSCHRIFT

(11) **EP 3 347 926 B1**
(45) Veröffentlichungstag und Bekanntmachung des Hinweises auf die Patenterteilung: **15.01.2020**
(21) Anmeldenummer: 16734723.6
(22) Anmeldetag: 06.07.2016
(51) Int. Cl.: H01L 41/293

(54) **VERFAHREN ZUM HERSTELLEN EINES ALS STAPEL AUSGEBILDETEN VIELSCHICHTAKTORS**
METHOD FOR MANUFACTURING MULTILAYER ACUATORS STRUCTURED AS A PILLAR
PROCÉDÉ DE FABRICATION DES ACTUATEURS MULTICOUCHES STRUCTURÉS EN TANT QU'UN EMPILEMENT

(30) Priorität: 10.09.2015 DE 102015217334
(43) Veröffentlichungstag der Anmeldung: 18.07.2018
(73) Patentinhaber: Continental Automotive GmbH, 30165 Hannover (DE)
(72) Erfinder: SCHÜRZ, Willibald, 93188 Pielenhofen (DE)
(86) Internationale Anmeldenummer: PCT/EP2016/066024
(87) Internationale Veröffentlichungsnummer: WO 2017/041924

(56) Entgegenhaltungen:
- DE-A1-102007 004 813
- DE-B3-102006 003 070
- US-A1- 2003 007 038

## Beschreibung

Die vorliegende Erfindung betrifft ein Verfahren zum elektrischen Kontaktieren eines Vielschichtaktors, der eine Mehrzahl von auf Anlegen eines elektrischen Feldes reagierenden Werkstoffschichten sowie eine Mehrzahl von Elektrodenschichten aufweist und bei dem die einzelnen Werkstoffschichten jeweils zwischen zwei einander benachbarten Elektrodenschichten angeordnet sind. Ein solcher Vielschichtaktor aus übereinander und alternierend zueinander gestapelten Schichten von Werkstoffschicht und Elektrodenschicht stellt ein elektronisches Bauelement dar und wird allgemein als Stapel bezeichnet. Das heutzutage wohl bekannteste elektronische Bauelement dieser Art ist ein allgemein als Piezoaktor bezeichneter Stapel, der als Betätigungselement in Einspritzventilen der verschiedensten Motortypen für Kraftfahrzeuge zur Anwendung kommt. Die Werkstoffschichten sind bei diesem Piezoaktor Keramikschichten.

Üblicherweise weist ein solcher Stapel, in Draufsicht betrachtet, einen rechteckigen oder quadratischen Querschnitt auf. Er wird an zwei sich gegenüberliegenden Umfangsseiten elektrisch kontaktiert. Zur vollflächigen Kontaktierung, bei der sich die Elektrodenschichten über die gesamte Fläche der Werkstoffschichten erstrecken, so dass keine piezoelektrisch inaktiven bzw. passiven Bereiche vorhanden sind, schlägt die DE 10 2006 003 070 B3 vor, eine jeweilige Isolationsschicht auf einen jeweiligen von zwei geometrisch nicht zusammenhängenden Stapelumfangsbereichen des Stapels, aufzubringen. Dann wird die genaue Position einer jeweiligen der Elektrodenschichten entlang der Stapelumfangsbereiche ermittelt. Anschließend werden mittels Laserstrukturieren erste Kontaktlöcher durch die erste Isolationsschicht der Isolationsschichten hin zu jeder zweiten der Elektrodenschichten erzeugt sowie zweite Kontaktlöcher durch die zweite der Isolationsschichten hin zu den verbleibenden der Elektrodenschichten. Abschließend werden die Isolationsschichten im Wesentlichen ganzflächig mit einem elektrisch leitenden Material bedeckt, wobei die Kontaktlöcher ebenfalls mit dem elektrisch leitenden Material gefüllt werden. Da die Querschnittsfläche eines solchen Stapels - in Draufsicht betrachtet - nur wenige Quadratmillimeter beträgt, während die Höhe des Stapel mehrere Zentimeter beträgt, ist die Handhabung des Stapels zur Durchführung der einzelnen Schritte schwierig.

Um den Herstellungsaufwand von voll-aktiven piezoelektrischen Vielschichtaktoren zu reduzieren, schlägt die DE 10 2007 004 813 A1 vor, den größten Teil der Herstellungsschritte an einem Vielschicht-Riegel im Grünzustand vorzunehmen. Dieser Vielschicht-Riegel bietet die Möglichkeit, gleichzeitig eine Mehrzahl von piezoelektrischen Vielschichtaktoren herzustellen, indem der Vielschicht-Riegel am Ende des Herstellungsverfahrens in einzelne Vielschichtaktoren getrennt wird. Die Bearbeitung des keramischen Materials im Grünzustand erleichtert zwar die Fertigung. Allerdings kann der Vielschicht-Riegel nach dem Sintern seine äußeren Maße in unvorhersehbarer Weise verändern, was für Betätigungselemente in Einspritzventilen, bei denen es auf höchste Präzision ankommt, zu Problemen führen kann.

Die US 2003/007038 A1 offenbart ein Verfahren zum Herstellen eines Vielschichtaktors, der aus einem in Stapelrichtung wesentlich längeren Aktorstapel heraus getrennt ist.

Es ist Aufgabe der Erfindung, ein Verfahren anzugeben, welches die Herstellung von Vielschichtaktoren mit hoher Präzision bei gleichzeitig einfacher Handhabung erlaubt.

Diese Aufgabe wird durch ein Verfahren mit den Merkmalen des Anspruchs 1 gelöst. Vorteilhafte Ausgestaltungen ergeben sich aus den abhängigen Ansprüchen.

Es wird ein Verfahren zum Herstellen eines als Stapel ausgebildeten Vielschichtaktors vorgeschlagen, welcher aus einer Mehrzahl von auf Anlegen eines elektrischen Feldes reagierenden Werkstoffschichten und einer Mehrzahl von Elektrodenschichten gebildet ist, wobei jede Werkstoffschicht zwischen zwei der Elektrodenschichten angeordnet ist. Bei dem Verfahren werden folgende Schritte durchgeführt:
a) Aufbringen einer jeweiligen Isolationsschicht auf einen jeweiligen von zwei geometrisch nicht zusammenhängenden Umfangsbereichen;
b) Erzeugen von ersten Kontaktlöchern durch eine erste Isolationsschicht der Isolationsschichten hin zu jeder zweiten der Elektrodenschichten, insbesondere mittels Laserstrukturieren;
c) Erzeugen von zweiten Kontaktlöchern durch eine zweite der Isolationsschichten hin zu den verbleibenden der Elektrodenschichten, insbesondere mittels Laserstrukturieren; und
d) zumindest im Wesentlichen ganzflächiges Bedecken der jeweiligen Isolationsschichten mit einem elektrisch leitenden Material, wobei die Kontaktlöcher mit dem elektrisch leitenden Material gefüllt werden.

Das Verfahren zeichnet sich durch folgende Schritte aus: Durchführen der Schritte a) bis d) an einem gesinterten Vielschicht-Riegel, der aus einer abwechselnden Anordnung der Mehrzahl der Werkstoffschichten und der Mehrzahl von Elektrodenschichten in einer Stapelrichtung des Vielschicht-Riegels besteht, wobei eine Tiefe des Riegels senkrecht zur Stapelrichtung einer Tiefe des Vielschichtaktors (und der zu erzeugenden Vielschichtaktoren entspricht) und eine Breite des Vielschicht-Riegels senkrecht zur Stapelrichtung einer Breite einer Mehrzahl von Vielschichtaktoren entspricht; und Trennen des Vielschicht-Riegels parallel zu dessen Tiefen- und Stapelrichtung in die Mehrzahl an Vielschichtaktoren als Schritt e) .

Erfindungsgemäß ist vorgesehen, dass in Schritt b) für jede zweite der Elektrodenschichten in Breitenrichtung des Vielschicht-Riegels jeweils eine der Anzahl der Vielschichtaktoren entsprechende Anzahl an ersten Kontaktlöchern erzeugt wird, welche voneinander beabstandet sind.

Wenn in der vorliegenden Beschreibung von ersten bzw. zweiten Kontaktlöchern die Rede ist, so sind hierunter nicht nur runde Öffnungen, sondern insbesondere auch längliche Schlitze (Kontaktschlitze) zu verstehen. Allgemein können die ersten bzw. zweiten Kontaktlöcher eine mehr oder minder beliebige Randkontur aufweisen.

Das Verfahren beruht auf der Durchführung der wesentlichen Prozessschritte nicht an einem einzelnen Stapel, sondern an einem bereits gesinterten Vielschicht-Riegel. Das Trennen des Vielschichtriegels in die einzelnen Vielschichtaktoren erfolgt am Ende der Prozesskette. Dadurch verringern sich der Aufwand in Bezug auf Vorrichtungen sowie Zeitaufwand zur Positionierung von Werkzeugteilen. Des Weiteren wird durch das Verfahren die Prozessrobustheit verbessert, da die Handhabung von Vielschicht-Riegeln im Vergleich zu einzelnen Vielschichtaktoren einfacher ist. Insbesondere verringert sich die Gefahr von Beschädigungen an der Keramik eines Stapels oder an bereits prozessierten Kontaktierungselementen. In der Summe reduzieren sich die Herstellkosten einer vollaktiven Kontaktierung eines Vielschichtaktors.

Es ist zweckmäßig, wenn der Vielschicht-Riegel vor dem Durchführen der Schritte a) bis d) geschliffen wird. Dadurch lassen sich alle folgenden Verfahrensschritte mit hoher Genauigkeit durchführen.

Gemäß einer weiteren Ausgestaltung wird in Schritt a) die jeweilige Isolationsschicht auf den gegenüberliegenden Hauptflächen vollflächig aufgebracht, wobei die Hauptflächen in einer jeweiligen Ebene parallel zur Stapelrichtung und zur Breitenrichtung des Vielschicht-Riegels liegen. Als Isolationsschicht können Schichten aus Polyimid, Glas, Keramik oder aus einem temperaturbeständigen Kunststoff aufgebracht werden. Das Aufbringen der Isolationsschichten kann mittels üblicher Siebdruck- oder Sprühprozesse erfolgen, denen sich dann wenigstens ein Trocknungs- und Einbrennprozess anschließt.

In entsprechender Weise ist vorgesehen, dass in Schritt c) für die verbleibenden Elektrodenschichten in Breitenrichtung jeweils eine der Anzahl der Vielschichtaktoren entsprechende Anzahl an zweiten Kontaktlöchern erzeugt wird, welche voneinander beabstandet sind. Die Anzahl an ersten Kontaktlöchern sowie die Anzahl an zweiten Kontaktlöchern, welche in Breitenrichtung verteilt sind, sind vorzugsweise regelmäßig beabstandet. Es ist weiterhin vorgesehen, dass die ersten und die zweiten Kontaktlöcher, die einem jeweiligen Vielschichtaktor zugeordnet sind, in Stapelrichtung übereinander ausgerichtet sind. Dadurch ist es möglich, in den Abschnitten der Beabstandung den Vielschicht-Riegel in Schritt e) auf einfache Weise zu trennen.

Gemäß einer weiteren Ausgestaltung ist vorgesehen, eine Hilfselektrode an einer in Breitenrichtung liegenden Stirnseite des Vielschicht-Riegels anzuordnen, welche eine elektrische Verbindung zu den ersten und den zweiten Elektrodenschichten aufweist, so dass, wenn der Vielschicht-Riegel zwischen Schritt c) und d) in eine Elektrolytlösung getaucht wird und ein elektrisches Potential an die Hilfselektrode angelegt wird, eine galvanische Verstärkung der durch die ersten und zweiten Kontaktlöcher freigelegten ersten und zweiten Elektrodenschichten erfolgt. Dadurch wird die Anbindung des elektrisch leitenden Materials, z.B. eines Leitklebers, erleichtert, da die Kontaktfläche zwischen den Elektrodenschichten und den elektrisch leitfähigen Partikeln in dem Leitkleber durch die galvanische Verstärkung vergrößert ist. Zusätzlich oder alternativ zum Vorsehen der galvanischen Verstärkung können zwischen Schritt c) und d) die Hauptflächen gesputtert werden, um die durch die ersten und zweiten Kontaktlöcher freigelegten ersten und zweiten Elektrodenschichten flächenmäßig zu vergrößern. Wird das Sputtern zusätzlich zur galvanischen Verstärkung durchgeführt, so erfolgt zunächst die galvanische Verstärkung und anschließend der Prozess des Sputterns, wodurch der Vorteil der elektrolytisch vergrößerten Innenelektrode für eine Verbesserung der Kontaktierung genutzt werden kann.

Eine weitere Ausgestaltung sieht vor, dass in Schritt d) in das elektrisch leitende Material ein Kontaktelement eingelegt wird, welches sich über die gesamte Hauptfläche des Vielschicht-Riegels erstreckt und für jeden zu erzeugenden Vielschichtaktor Anschlusselemente umfasst. Nach dem Schritt des Trennens (Schritt e)) weist jeder der Vielschichtaktoren ein jeweiliges Kontaktelement auf, welches die Kontaktierung und Ansteuerung der ersten und zweiten Elektrodenschichten ermöglicht. Hierzu kann das Kontaktelement beispielsweise entsprechende, nach außen geführte Anschlussleitungen umfassen.

Es ist weiterhin zweckmäßig, wenn das Trennen des Vielschicht-Riegels in Schritt e) mittels Drahtsägen erfolgt. Das Verfahren des Drahtsägens weist den Vorteil auf, dass keine weiteren Nachbearbeitungsschritte der Schnittflächen notwendig sind.

Der Schritt e) des Abtrennens umfasst darüber hinaus, sofern diese vorgesehen wurde, das Abtrennen der Hilfselektrode von dem Vielschicht-Riegel.

Die Erfindung wird nachfolgend näher anhand eines Ausführungsbeispiels in der Zeichnung erläutert. Es zeigen:
- Fig. 1: einen aus dem Stand der Technik bekannten Vielschichtaktor in einer geschnittenen Ansicht;
- Fig. 2: einen Schnitt durch den in Fig. 1 dargestellten Vielschichtaktor;
- Fig. 3: einen erfindungsgemäß im Rahmen der Herstellung genutzten Vielschicht-Riegel, bei dem eine Isolationsschicht mit jeweiligen Vielschichtaktoren zugeordneten Strukturierungsfeldern versehen ist;
- Fig. 4: einen vergrößerten und zwecks Illustrationszwecken teildurchsichtigen Ausschnitt des Vielschicht-Riegels aus Fig. 3; und
- Fig. 5: einen vergrößerten Ausschnitt eines für die Herstellung erfindungsgemäß genutzten Vielschicht-Riegels, wobei galvanische Verstärkungen im Bereich freigelegter Elektrodenschichten erkennbar sind.

In den Figuren sind gleiche Elemente mit gleichen Bezugszeichen versehen. Ferner sind die Figuren teilweise mit einem Koordinatensystem versehen, welche deren jeweilige Raumrichtung angeben. Dabei kennzeichnet ein Index "S" eine Raumrichtung eines Vielschichtaktors und "R" die Raumrichtung eines Vielschicht-Riegels. Sofern sich die Erstreckungsrichtungen des Vielschichtaktors und des Vielschicht-Riegels entsprechen, ist dies in den jeweiligen Koordinatensystemen durch ein "=" angegeben.

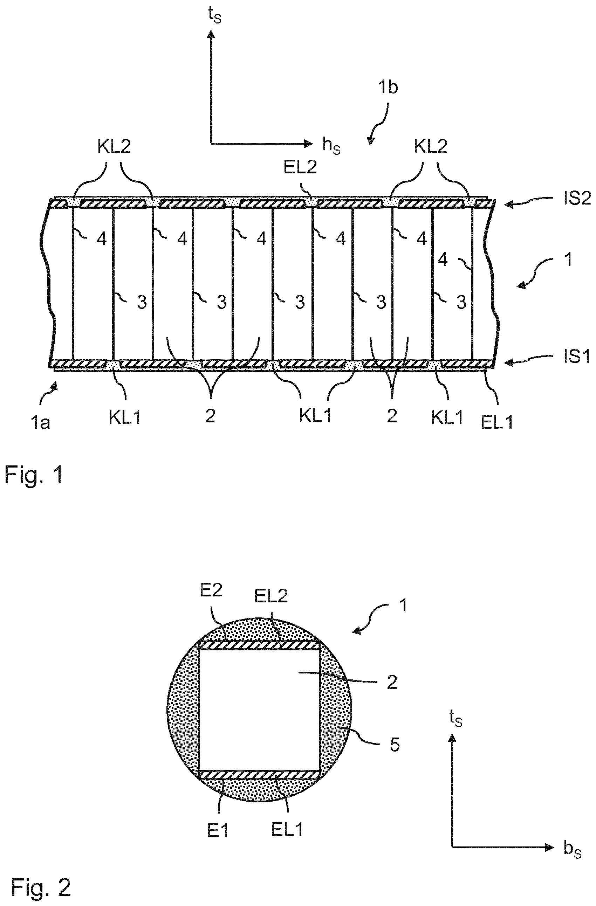

Fig. 1 zeigt einen aus dem Stand der Technik bekannten Vielschichtaktor, dessen Aufbau prinzipiell dem in der eingangs bereits beschriebenen DE 10 2006 003 070 B3 beschriebenen elektronischen Bauelement entspricht. Der Vielschichtaktor in Gestalt eines Stapels 1 umfasst eine Mehrzahl an übereinander gestapelten Werkstoffschichten 2. Die Werkstoffschichten 2 bestehen aus einer piezoelektrischen Keramik. Zwischen zwei Werkstoffschichten 2 ist alternierend eine Elektrodenschicht 3 oder 4 angeordnet. Der aus den Werkstoffschichten 2 und den Elektrodenschichten 3, 4 gebildete Stapel 1 ist derart ausgebildet, dass sich die Elektrodenschichten 3, 4 bis an die jeweiligen Ränder der Werkstoffschichten 2 und damit des Stapels 1 geführt sind.

Der Stapel 1 ist an zwei geometrisch nicht zusammenhängenden Umfangsbereichen 1a und 1b mit einer jeweiligen Isolationsschicht IS1 bzw. IS2 überzogen. Als Isolationsschicht IS1, IS2 können Schichten aus Polyimid, Glas, Keramik oder aus einem temperaturbeständigen Kunststoff aufgebracht werden. Unter temperaturbeständig ist dabei zu verstehen, dass der Kunststoff gegenüber solchen Temperaturen beständig ist, denen das zu fertigende elektronische Bauelement in seinem späteren Betrieb ausgesetzt sein wird. Das Aufbringen der Isolationsschichten IS1, IS2 kann dabei mittels üblicher Siebdruck- oder Sprühprozesse erfolgen, denen sich dann wenigstens ein Trocknungs- und ein Brennprozess anschließt.

Durch die Isolationsschichten IS1, IS2 hindurch sind zu den jeweiligen Elektrodenschichten 3, 4 Kontaktlöcher KL1, KL2 derart erzeugt, dass die Kontaktlöcher KL1 zu den ersten Elektrodenschichten 3 und die Kontaktlöcher KL2 zu den zweiten Elektrodenschichten 4 führen.

Die Erzeugung der ersten und zweiten Kontaktlöcher KL1, KL2 erfolgt im Anschluss an die Ermittlung der genauen Position jeder einzelnen der Elektrodenschichten 3, 4. Somit werden erste Kontaktlöcher KL1 durch die eine Isolationsschicht IS1 hindurch zu den ersten Elektrodenschichten 3 hin erzeugt. Ferner werden zweite Kontaktlöcher KL2 durch die zweite Isolationsschicht IS2 hindurch zu den Elektrodenschichten 4 hin erzeugt. Die Kontaktlöcher KL1, KL2 werden in ihrem Durchmesser vorteilhafterweise so dimensioniert, dass dieser z.B. einem Viertel der Dicke einer Werkstoffschicht 2 entspricht. Die Kontaktlöcher KL1, KL2 werden z.B. mittels Laserstrukturieren erzeugt. Alternativ können diese auch mittels allgemein üblicher chemischer oder elektrochemischer Verfahren erzeugt werden. Das Strukturieren mittels Laser kann beispielsweise mittels sog. Ultrakurzpulslaser durchgeführt werden.

Anschließend werden beide Isolationsschichten IS1, IS2 ganzflächig mit einem elektrisch leitenden Material EL1, EL2, wie z.B. einem elektrisch leitfähigen Kleber, überzogen. Alternativ kann auch eine Metallschicht, insbesondere eine Lotschicht, erzeugt werden. Vorbereitend der Aufbringung des elektrisch leitenden Materials EL1, EL2 kann ein Sputterprozess durchgeführt werden, um die Anbindung des elektrisch leitenden Materials an die Stirnseiten der Elektrodenschichten 3, 4 zu verbessern. Wie ohne weiteres aus Fig. 1 ersichtlich ist, werden auch die Kontaktlöcher KL1, KL2 mit dem elektrisch leitenden Material EL1, EL2 gefüllt, so dass die Elektrodenschichten 3, 4 elektrisch kontaktiert sind. Das elektrisch leitende Material EL1, EL2 steht dann für einen elektrischen Anschluss des elektronischen Bauelements an eine elektrische Spannung in Form von zwei elektrisch voneinander isolierten Sammelelektroden zur Verfügung. Um die elektrische Kontaktierung dieser Sammelelektroden E1, E2 zu vereinfachen, kann nach oder während des Aufbringens des elektrisch leitenden Materials EL1, EL2 ein Kontaktelement in das elektrisch leitende Material EL1, EL2 eingebracht werden, welches elektrische Anschlüsse zu deren Kontaktierung umfasst.

Fig. 2 zeigt einen Schnitt in Tiefenrichtung t_{S} des Vielschichtaktors aus Fig. 1. Dabei ist ferner ersichtlich, dass in einem weiteren Verfahrensschritt der so vorbereitete Vielschichtaktor 1 von einer in etwa kreisförmigen Isolierung 5, z.B. aus Silikon, umgeben ist. Ebenso sind die einander gegenüberliegenden und elektrisch voneinander isolierten Sammelelektroden E1 und E2 erkennbar.

Die oben beschriebenen Prozessschritte zur Herstellung eines vollaktiven Vielschichtaktors werden in entsprechender Weise erfindungsgemäß nicht an einem einzelnen Stapel, bestehend aus Werkstoffschichten und dazwischenliegenden Elektrodenschichten, durchgeführt, sondern an einem Vielschicht-Riegel 10.

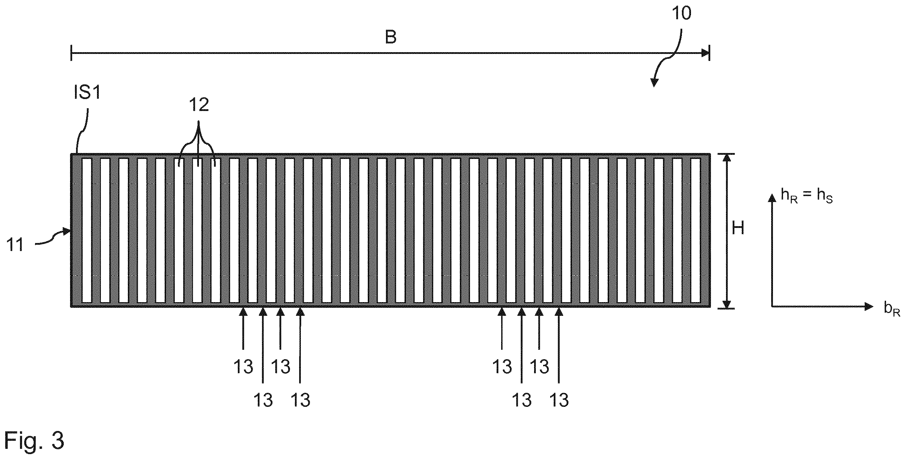

Ein Vielschicht-Riegel 10, welcher in schematischer Weise in Fig. 3 dargestellt ist, besteht aus der bereits gesinterten und geschliffenen Piezokeramik der übereinandergestapelten Werkstoffschichten 2 mit den dazwischen angeordneten Elektrodenschichten 3, 4. Der Vielschicht-Riegel 10 beinhaltet in Breitenrichtung b_{R} eine Vielzahl von einzelnen Vielschichtaktoren. Seine Seite B entspricht in etwa der Anzahl der Vielschichtaktoren, multipliziert mit der Breite eines Vielschichtaktors. Die Höhe H des Riegels und die Dicke des Vielschicht-Riegels 10 entsprechen den endgültigen Abmessungen des Vielschichtaktors. Nachfolgend werden die einzelnen Prozessschritte beschrieben.

Auf gegenüberliegende Hauptflächen wird eine Isolationsschicht aufgebracht. In der Darstellung der Fig. 3 ist lediglich eine der Hauptflächen 11 erkennbar. Die Hauptfläche 11 liegt in einer Ebene parallel zur Stapelrichtung h_{R} = h_{S} und zur Breitenrichtung b_{R} des Vielschicht-Riegels 10. In entsprechender Weise wird die Isolationsschicht IS2 auf die gegenüberliegende Hauptfläche des Vielschicht-Riegels 10 aufgebracht. Die Isolationsschichten IS1, IS2 sind beispielsweise Polyimid-Schichten zur Passivierung der Hauptfläche, welche durch Siebdruck- oder Sprühprozesse aufgebracht werden. Die Isolationsschichten IS1, IS2 können auch, wie oben beschrieben, aus Glas, Keramik oder temperaturbeständigem Kunststoff bestehen.

Fig. 3 zeigt den Vielschicht-Riegel mit bereits durchgeführter Strukturierung, d.h. mit bereits erzeugten Kontaktlöchern KL1 (in Fig. 3 nicht im Detail erkennbar). Hierzu werden die Isolationsschichten IS1, IS2 selektiv in der Breite abgetragen, wobei die Breite eines dadurch gebildeten Strukturierungsfelds 12 in etwa der Kontaktierungsbreite eines einzelnen Vielschichtaktors entspricht (oder etwas geringer ist).

Der Zwischenraum 13 zwischen zwei Strukturierungsfeldern 12 dient am Ende der Prozesskette zum Trennen des Vielschicht-Riegels 10 in die einzelnen Vielschichtaktoren.

Als vorbereitende Maßnahme dafür wird zunächst die genaue Position jeder einzelnen der Elektrodenschichten 3, 4, bezogen auf die Höhe des Stapels 1, ermittelt. Dies ist notwendig, da die einzelnen Werkstoffschichten 2 nie exakt genau ein und dieselbe Schichtdicke aufweisen, sondern die Schichtdicken innerhalb eines vorgegebenen Toleranzmaßes voneinander verschieden sind. Da ein fertiger Vielschichtaktor in der Regel zwischen 300 und 450 Werkstoffschichten 2 aufweist, lassen sich die exakten Positionen der Elektrodenschichten 3, 4 nicht berechnen, sondern nur ermitteln. Die Kenntnis der exakten Positionen ist jedoch deshalb wichtig, damit sich die Kontaktlöcher KL1, KL2 an den Stirnflächen der Elektrodenschichten 3, 4 exakt mittig bezüglich der Dicke der jeweiligen Elektrodenschicht 3 bzw. 4 erzeugen lassen. Die Positionen können beispielsweise mittels allgemein üblicher optischer Messverfahren ermittelt werden.

Jedes der Strukturierungsfelder 12 besteht aus einer Vielzahl an ersten Kontaktlöchern KL1, wobei sich die ersten Kontaktlöcher KL1 in Breitenrichtung b_{R} erstrecken. Dabei sind die ersten Kontaktlöcher KL1 für jede zweite der Elektrodenschichten 3 übereinander erzeugt. In der zeichnerischen Darstellung ergibt sich dadurch das jeweilige hell eingefärbte Strukturierungsfeld 12. Weist der Vielschicht-Riegel 10 beispielsweise 150 erste Elektrodenschichten 3 auf, welche über die ersten Kontaktlöcher KL1 (entsprechend der Beschreibung in Fig. 1) zugänglich gemacht werden sollen, so umfasst ein Strukturierungsfeld 12 150 übereinander angeordnete und voneinander beabstandete in Breitenrichtung b_{R} verlaufende erste Kontaktlöcher KL1.

In entsprechender Weise werden entsprechende Strukturierungsfelder 12 auch auf der nicht sichtbaren, hinteren Breitseite des Vielschicht-Riegels 10 erzeugt.

Im nächsten Schritt erfolgt das Auftragen einer Sputterschicht (nicht gezeigt) in den Bereichen, welche strukturiert wurden. Dies betrifft die Strukturierungsfelder 12 mit den darin eingebrachten Kontaktlöchern. Anschließend wird z.B. mittels eines Siebdruckprozesses die elektrisch leitende Schicht, z.B. ein Leitkleber, gezielt im Kontaktierungsbereich, d.h. in einem jeweiligen Strukturierungsfeld 12, ganzflächig aufgetragen. Optional können die bereits erwähnten Kontaktelemente in die elektrisch leitende Schicht eingelegt werden.

Nach dem Aushärten des elektrisch leitenden Materials, das in Fig. 3 nicht gezeigt ist, erfolgt das Trennen des Vielschicht-Riegels 10 in die Vielschichtaktoren im Bereich der Zwischenräume 13. Das Trennen erfolgt dabei parallel zu dessen Tiefenrichtung t_{S} und parallel zur Stapelrichtung h_{S}. Vorzugsweise wird zum Trennen das bekannte Drahtsägeverfahren angewendet, welches keinerlei Nachbearbeitung der Schnittflächen erfordert.

Der Vorteil der Ausführung der an sich bekannten Verfahrensschritte in einem gesinterten und geschliffenen Vielschicht-Riegel liegt darin, dass sich der Aufwand bezüglich erforderlicher Vorrichtungen zum Positionieren von Werkzeugen bzw. zur Abdeckung von nicht zu kontaktierenden Bereichen wesentlich verringert. Diese Tätigkeiten müssen für eine jeweilige Hauptfläche des Vielschicht-Riegels lediglich einmal gemacht werden. Bei der konventionellen Herstellung, wie diese in Verbindung mit Fig. 1 beschrieben wurde, sind die entsprechenden Schritte für jeden Vielschichtaktor durchzuführen.

Da die Handhabung eines Vielschicht-Riegels 10 im Vergleich zu einem einzelnen Vielschichtaktor aufgrund seiner Größe auch deutlich einfacher ist, kann durch die Bearbeitung des Vielschicht-Riegels auch die Prozessrobustheit verbessert werden.

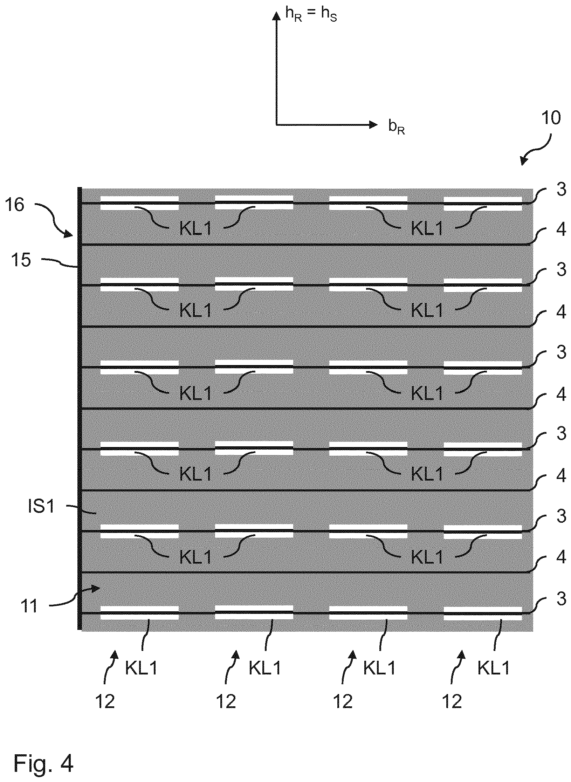

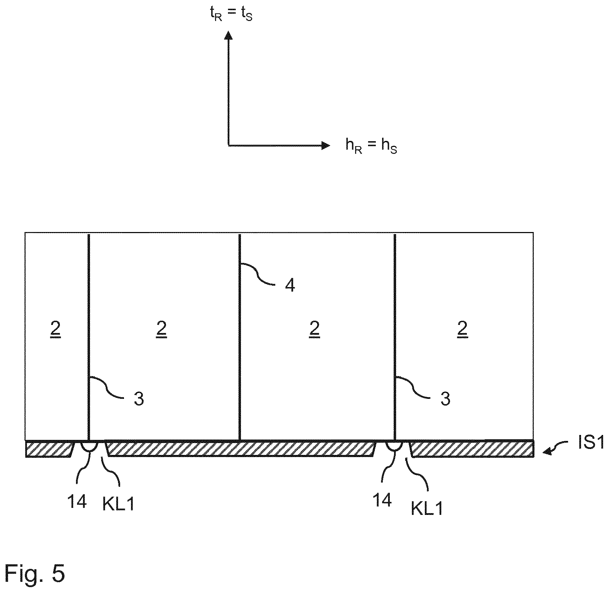

Ein weiterer vorteilhafter, optionaler Verfahrensschritt, welcher durch die Bearbeitung im Vielschicht-Riegel auf einfache Weise ermöglicht wird, besteht darin, die Elektrodenschichten 3, 4 im Bereich der freigelegten Kontaktlöcher KL1, KL2 elektrolytisch zu verstärken. Dies wird nachfolgend unter Bezugnahme auf die Figuren 4 und 5 beschrieben.

Fig. 4 zeigt einen Ausschnitt eines wie in Fig. 3 beschriebenen Vielschicht-Riegels 10. In diesem Ausschnitt sind beispielhaft vier in Breitenrichtung b_{R} nebeneinander angeordnete Strukturierungsfelder 12 angeordnet. Gut zu erkennen ist, dass für die ersten Elektrodenschichten 3 jeweilige Kontaktlöcher KL1 erzeugt sind, welche sich über die Breite eines jeweiligen Strukturierungsfelds 12 in Breitenrichtung b_{R} des Vielschicht-Riegels 10 erstrecken. Lediglich zur Veranschaulichung sind auch die zweiten Elektrodenschichten 4 dargestellt, welche bei Betrachtung der Hauptfläche 11 und der aufgebrachten Isolationsschicht IS1 an sich nicht sichtbar sind.

In dieser Darstellung ist eine Hilfselektrode 15 an einer in Breitenrichtung b_{R} liegenden Stirnseite 16 des Vielschicht-Riegels 10 angeordnet. Die Hilfselektrode 15 weist eine elektrische Verbindung sowohl zu den ersten als auch zu den zweiten Elektrodenschichten 3, 4 auf. Aus diesem Grund ist es ausreichend, eine solche Hilfselektrode 15 an lediglich einer der beiden Stirnseiten des Vielschicht-Riegels 10 vorzusehen. Die Erzeugung der Hilfselektrode 15 kann vor dem Erzeugen der Isolationsschicht IS1, IS2 und dem Erzeugen der Kontaktlöcher KL1, KL2 durchgeführt werden. Wird der so vorbereitete Vielschicht-Riegel 10 in eine Lösung getaucht, welche Metallionen, wie z.B. Ag⁺, Pd²⁺, Cu²⁺, enthält, und an der Hilfselektrode 15 eine negative Spannung angelegt, so baut sich an den freigelegten Elektrodenschichten 3, 4 galvanisch eine Metallschicht auf, welche als galvanische Verstärkung 14 (siehe Fig. 5) wirkt. Dadurch können die Stirnseiten der Elektrodenschichten 3, 4 galvanisch verstärkt werden und wahlweise der oben beschriebene Sputterprozess eliminiert oder bevorzugt unterstützt werden.

Die weitere Prozessierung, die das Auftragen des elektrisch leitenden Materials EL1, EL2 umfasst, sowie das Trennen der Vielschichtaktoren aus dem Vielschicht-Riegel 10 erfolgt analog zur vorher beschriebenen Beschreibung.

## Patentansprüche

1. Verfahren zum Herstellen eines als Stapel (1) ausgebildeten Vielschichtaktors, welcher aus einer Mehrzahl von auf Anlegen eines elektrischen Feldes reagierenden Werkstoffschichten (2) und einer Mehrzahl von Elektrodenschichten (3, 4) gebildet ist, wobei jede Werkstoffschicht (2) zwischen zwei der Elektrodenschichten (3, 4) angeordnet ist, bei dem folgende Schritte durchgeführt werden:
a) Aufbringen einer jeweiligen Isolationsschicht (IS1, IS2) auf einen jeweiligen (1a, 1b) von zwei geometrisch nicht zusammenhängenden Umfangsbereichen (1a, 1b);
b) Erzeugen von ersten Kontaktlöchern (KL1) durch eine erste Isolationsschicht (IS1) der Isolationsschichten (IS1, IS2) hin zu jeder zweiten (3) der Elektrodenschichten (3, 4), insbesondere mittels Laserstrukturieren;
c) Erzeugen von zweiten Kontaktlöchern (KL2) durch eine zweite (IS2) der Isolationsschichten (IS1, IS2) hin zu den verbleibenden (4) der Elektrodenschichten (3, 4), insbesondere mit Laserstrukturieren; und
d) zumindest im Wesentlichen ganzflächiges Bedecken der jeweiligen Isolationsschichten (IS1, IS2) mit einem elektrisch leitenden Material (EL1, EL2), wobei die Kontaktlöcher (KL1, KL2) mit dem elektrisch leitenden Material (EL) gefüllt werden;
- Durchführen der Schritte a) bis d) an einem gesinterten Vielschicht-Riegel (10), der aus einer abwechselnden Anordnung der Mehrzahl der Werkstoffschichten (2) und der Mehrzahl von Elektrodenschichten (3, 4) in einer Stapelrichtung (h_{S}) des Vielschicht-Riegels (10) besteht, wobei eine Tiefe des Riegels (10) senkrecht zur Stapelrichtung (h_{S}) einer Tiefe des Vielschichtaktors und eine Breite (B) des Vielschicht-Riegels (10) senkrecht zur Stapelrichtung (h_{S}) einer Breite einer Mehrzahl von Vielschichtaktoren entspricht; und
- Trennen des Vielschicht-Riegels (10) parallel zu dessen Tiefen (t_{S})- und Stapelrichtung (h_{S}) in die Mehrzahl an Vielschichtaktoren als Schritt e)
wobei
in Schritt b) für jede zweite der Elektrodenschichten (3) in Breitenrichtung (b_{R}) jeweils eine der Anzahl der Vielschichtaktoren entsprechende Anzahl an ersten Kontaktlöchern (KL1) erzeugt wird, welche voneinander beabstandet sind.

2. Verfahren nach Anspruch 1, bei dem der Vielschicht-Riegel (10) vor dem Durchführen der Schritte a) bis d) geschliffen wird.

3. Verfahren nach Anspruch 1 oder 2, bei dem in Schritt a) die jeweilige Isolationsschicht (IS1, IS2) auf den gegenüberliegenden Hauptflächen (11) vollflächig aufgebracht wird, wobei die Hauptflächen (11) in einer jeweiligen Ebene parallel zur Stapelrichtung (h_{S}) und zur Breitenrichtung (b_{R}) des Vielschicht-Riegels (10) liegen.

4. Verfahren nach einem der vorhergehenden Ansprüche, bei dem in Schritt c) für die verbleidenden Elektrodenschichten (3) in Breitenrichtung (b_{R}) jeweils eine der Anzahl der Vielschichtaktoren entsprechende Anzahl an zweiten Kontaktlöchern (KL2) erzeugt wird, welche voneinander beabstandet sind.

5. Verfahren nach Anspruch 4, bei dem die ersten und die zweiten Kontaktlöcher (KL1, KL2), die einem jeweiligen Vielschichtaktor zugeordnet sind, in Stapelrichtung (h_{S}) übereinander ausgerichtet sind.

6. Verfahren nach einem der vorhergehenden Ansprüche, bei dem eine Hilfselektrode (15) an einer in Breitenrichtung (b_{R}) liegenden Stirnseite (16) des Vielschicht-Riegels (10) angeordnet wird, welche eine elektrische Verbindung zu den ersten und den zweiten Elektrodenschichten (3, 4) aufweist, so dass, wenn der Vielschicht-Riegel (10) zwischen Schritt c) und d) in eine Elektrolytlösung getaucht wird und ein elektrisches Potential an die Hilfselektrode (15) angelegt wird, eine galvanische Verstärkung der durch die ersten und zweiten Kontaktlöcher (KL1, KL2) freigelegten ersten und zweiten Elektrodenschichten (3, 4) erfolgt.

7. Verfahren nach einem der vorhergehenden Ansprüche, bei dem zwischen Schritt c) und d) die Hauptflächen (11) gesputtert werden, um die durch die ersten und zweiten Kontaktlöcher (KL1, KL2) freigelegten ersten und zweiten Elektrodenschichten (3, 4) flächenmäßig zu vergrößern.

8. Verfahren nach einem der vorhergehenden Ansprüche, bei dem in Schritt d) in das elektrisch leitende Material (EL1, EL2) ein Kontaktelement eingelegt wird, welches sich über die gesamte Hauptfläche (11) des Vielschicht-Riegels (10) erstreckt und für jeden zu erzeugenden Vielschichtaktor Anschlusselemente umfasst.

9. Verfahren nach einem der vorhergehenden Ansprüche, bei dem das Trennen des Vielschicht-Riegels (10) in Schritt e) mittels Drahtsägen erfolgt.

10. Verfahren nach einem der Ansprüche 6 bis 9, bei dem der Schritt e) das Abtrennen der Hilfselektrode (15) von dem Vielschicht-Riegel (10) umfasst.

## Claims

1. Method for producing a multi-layer actuator designed as a stack (1) and formed from a plurality of material layers (2) that react to application of an electric field, and from a plurality of electrode layers (3, 4), wherein each material layer (2) is arranged between two of the electrode layers (3, 4), in which method the following steps are carried out:
a) applying a respective insulation layer (IS1, IS2) to a respective one (1a, 1b) of two geometrically non-continuous circumferential regions (1a, 1b);
b) producing first contact holes (KL1) through a first insulation layer (IS1) of the insulation layers (IS1, IS2) to every second electrode layer (3) from among the electrode layers (3, 4), in particular by means of laser structuring;
c) producing second contact holes (KL2) through a second insulation layer (IS2) of the insulation layers (IS1, IS2) to the remaining electrode layers (4) from among the electrode layers (3, 4), in particular by means of laser structuring; and
d) covering the respective insulation layers (IS1, IS2) with an electrically conductive material (EL1, EL2) at least substantially over the whole area, wherein the contact holes (KL1, KL2) are filled with the electrically conductive material (EL);
- carrying out steps a) to d) on a sintered multi-layer bar (10) consisting of an alternating arrangement of the plurality of material layers (2) and the plurality of electrode layers (3, 4) in a stacking direction (hₛ) of the multi-layer bar (10), wherein a depth of the bar (10) perpendicular to the stacking direction (hₛ) corresponds to a depth of the multi-layer actuator and a width (B) of the multi-layer bar (10) perpendicular to the stacking direction (hₛ) corresponds to a width of a plurality of multi-layer actuators; and
- separating the multi-layer bar (10) parallel to the depth direction (t_{S}) and stacking direction (h_{S}) thereof into the plurality of multi-layer actuators as step e) wherein
in step b) for every second electrode layer from among the electrode layers (3) in the width direction (b_{R}) in each case a number of first contact holes (KL1) corresponding to the number of multi-layer actuators are produced, which are spaced apart from one another.

2. Method according to Claim 1, wherein the multi-layer bar (10) is ground before steps a) to d) are carried out.

3. Method according to Claim 1 or 2, wherein in step a) the respective insulation layer (IS1, IS2) is applied over the whole area on the opposite main surfaces (11), wherein the main surfaces (11) lie in a respective plane parallel to the stacking direction (h_{S}) and to the width direction (b_{R}) of the multi-layer bar (10).

4. Method according to any of the preceding claims, wherein in step c) for the remaining electrode layers (3) in the width direction (b_{R}) in each case a number of second contact holes (KL2) corresponding to the number of multi-layer actuators are produced, which are spaced apart from one another.

5. Method according to Claim 4, wherein the first and second contact holes (KL1, KL2) assigned to a respective multi-layer actuator are aligned one above another in the stacking direction (h_{S}).

6. Method according to any of the preceding claims, wherein an auxiliary electrode (15) is arranged on an end side (16) of the multi-layer bar (10), said end side lying in the width direction (b_{R}), said auxiliary electrode being electrically connected to the first and the second electrode layers (3, 4), such that if the multi-layer bar (10) is dipped into an electrolyte solution between steps c) and d) and an electrical potential is applied to the auxiliary electrode (15), an electrolytic reinforcement of the first and second electrode layers (3, 4) exposed by the first and second contact holes (KL1, KL2) is effected.

7. Method according to any of the preceding claims, wherein between steps c) and d) the main surfaces (11) are sputtered in order to enlarge the areas of the first and second electrode layers (3, 4) exposed by the first and second contact holes (KL1, KL2).

8. Method according to any of the preceding claims, wherein in step d) a contact element is introduced into the electrically conductive material (EL1, EL2), which contact element extends over the entire main surface (11) of the multi-layer bar (10) and comprises connection elements for each multi-layer actuator to be produced.

9. Method according to any of the preceding claims, wherein separating the multi-layer bar (10) in step e) is effected by means of wire sawing.

10. Method according to any of Claims 6 to 9, wherein step e) comprises separating the auxiliary electrode (15) from the multi-layer bar (10).

## Revendications

1. Procédé de fabrication d'un actionneur multicouche réalisé en forme d'empilement (1), qui est formé d'une multiplicité de couches de matériau (2) réagissant à l'application d'un champ électrique et d'une multiplicité de couches d'électrode (3, 4), dans lequel chaque couche de matériau (2) est disposée entre deux des couches d'électrode (3, 4), dans lequel on exécute les étapes suivantes:
a) appliquer une couche isolante respective (IS1, IS2) sur une région respective (1a, 1b) de deux régions périphériques géométriquement non continues (1a, 1b);
b) produire des premiers trous de contact (KL1) à travers une première couche isolante (IS1) des couches isolantes (IS1, IS2) en direction de chaque deuxième (3) des couches d'électrode (3, 4), en particulier par structuration au laser;
c) produire des deuxièmes trous de contact (KL2) à travers une deuxième (IS2) des couches isolantes (IS1, IS2) en direction de la couche restante (4) des couches d'électrode (3, 4), en particulier par structuration au laser; et
d) recouvrir au moins essentiellement toute la surface des couches isolantes respectives (IS1, IS2) avec un matériau électriquement conducteur (EL1, EL2), dans lequel on remplit les trous de contact (KL1, KL2) avec le matériau électriquement conducteur (EL);
- exécuter les étapes a) à d) sur une barre multicouche frittée (10), qui se compose d'un agencement alterné de la multiplicité des couches de matériau (2) et de la multiplicité de couches d'électrode (3, 4) dans une direction d'empilement (h_{S}) de la barre multicouche (10), dans lequel une profondeur de la barre (10) perpendiculairement à la direction d'empilement (h_{S}) correspond à une profondeur de l'actionneur multicouche et une largeur (B) de la barre multicouche (10) perpendiculairement à la direction d'empilement (h_{S}) correspond à une largeur d'une multiplicité d'actionneurs multicouches; et
- partager la barre multicouche (10) parallèlement à sa profondeur (t_{S}) et à sa direction d'empilement (h_{S}) en une multiplicité d'actionneurs multicouches en tant qu'étape e), dans lequel on produit à l'étape b), pour chaque deuxième des couches d'électrode (3) dans la direction de la largeur (b_{R}), chaque fois un nombre de premiers trous de contact (KL1), qui sont espacés l'un de l'autre, correspondant au nombre des actionneurs multicouches.

2. Procédé selon la revendication 1, dans lequel on polit la barre multicouche (10) avant l'exécution des étapes a) à d).

3. Procédé selon une revendication 1 ou 2, dans lequel on applique à l'étape a) la couche isolante respective (IS1, IS2) à pleine surface sur les faces principales opposées (11), dans lequel les faces principales (11) sont situées dans un plan respectif parallèle à la direction d'empilement (h_{S}) et à la direction de la largeur (b_{R}) de la barre multicouche (10).

4. Procédé selon l'une quelconque des revendications précédentes, dans lequel on produit à l'étape c) pour les couches d'électrode restantes (3) dans la direction de la largeur (b_{R}) chaque fois un nombre de deuxièmes trous de contact (KL2), qui sont espacés l'un de l'autre, correspondant au nombre des actionneurs multicouches.

5. Procédé selon la revendication 4, dans lequel les premiers et les deuxièmes trous de contact (KL1, KL2), qui sont associés à un actionneur multicouche respectif, sont alignés l'un au-dessus de l'autre dans la direction d'empilement (h_{S}).

6. Procédé selon l'une quelconque des revendications précédentes, dans lequel une électrode auxiliaire (15) est disposée sur un côté frontal (16) de la barre multicouche (10) situé dans la direction de la largeur (b_{R}), qui présente une liaison électrique avec les premières et les deuxièmes couches d'électrode (3, 4), de telle manière que, lorsque la barre multicouche (10) est plongée dans une solution électrolytique entre l'étape c) et l'étape d) et qu'un potentiel électrique est appliqué à l'électrode auxiliaire (15), il se produise un renforcement galvanique des premières et des deuxièmes couches d'électrode (3, 4) laissées libres par les premiers et les deuxièmes trous de contact (KL1, KL2).

7. Procédé selon l'une quelconque des revendications précédentes, dans lequel on soumet les faces principales (11) à une pulvérisation cathodique entre les étapes c) et d), afin d'agrandir en surface les premières et les deuxièmes couches d'électrode (3, 4) laissées libres par les premiers et les deuxièmes trous de contact (KL1, KL2).

8. Procédé selon l'une quelconque des revendications précédentes, dans lequel on introduit à l'étape d) dans le matériau électriquement conducteur (EL1, EL2) un élément de contact, qui s'étend sur toute la face principale (11) de la barre multicouche (10) et comprend des éléments de raccord pour chaque actionneur multicouche à produire.

9. Procédé selon l'une quelconque des revendications précédentes, dans lequel on effectue le partage de la barre multicouche (10) à l'étape e) par sciage au fil.

10. Procédé selon l'une quelconque des revendications 6 à 9, dans lequel l'étape e) comprend la séparation de l'électrode auxiliaire (15) de la barre multicouche (10).
